# EUROPÄISCHE PATENTANMELDUNG

(11) **EP 1 536 468 A2**
(43) Veröffentlichungstag der Anmeldung: **01.06.2005**
(21) Anmeldenummer: 04026336.0
(22) Anmeldetag: 05.11.2004
(51) Int. Cl.: H01L 23/467, G06F 1/20

(54) **Kühlsystem zur Kühlung einer in einem Computersystem angeordneten elektronischen Komponente**

(30) Priorität: 28.11.2003 DE 10355597
(71) Anmelder: Fujitsu Siemens Computers GmbH, 80807 München (DE)
(72) Erfinder: Veh, Günther, 86856 Hiltenfingen (DE)
(74) Vertreter: Epping, Hermann, Fischer

(57) **Zusammenfassung**

Die vorliegende Erfindung betrifft ein Kühlsystem zur Kühlung einer in einem Computersystem (4) angeordneten elektronischen Komponente (2), wie z. B. einem Prozessor, mit einem Kühlkörper (3), der auf der elektronischen Komponente (2) angeordnet ist, wobei auf dem Kühlkörper (3) ein weiterer Kühlkörper (5) angeordnet ist, der zur Ableitung von Verlustwärme mit einer in dem Computersystem (4) angeordneten Kühlanordnung (8) thermisch leitend verbunden ist.

## Beschreibung

Die Erfindung betrifft ein Kühlsystem zur Kühlung einer in einem Computersystem angeordneten elektronischen Komponente mit einem Kühlkörper, der auf der elektronischen Komponente angeordnet ist.

Zunehmende Verlustleistungen von elektronischen Komponenten eines Computersystems aufgrund immer höherer Integrationsdichten und höherer Taktraten in elektronischen Schaltungen verursachen auch eine Zunahme von Verlustwärme. Wird die Verlustwärme nicht zuverlässig von den wärmeentwickelnden Komponenten, wie beispielsweise Prozessoren, abgeführt, indem für eine ausreichende Kühlung an bzw. in unmittelbarer Umgebung dieser Komponenten gesorgt wird, können Fehlfunktionen oder ein völliger Ausfall der Komponente als Folge einer thermischen Überbelastung eintreten.

Zur Gewährleistung einer ausreichenden Kühlung werden die Bauteile mit Kühlkörpern versehen, deren Kühlrippen über die natürliche Konvektion mit Luft für einen ausreichenden Wärmeaustausch sorgen. Unterstützend werden zur Ableitung der entstehenden Verlustwärme elektronisch betriebene Lüfter eingesetzt.

Da die Temperatur einen wesentlichen Einfluß auf die Funktionalität und Zuverlässigkeit von Computersystem hat, werden insbesondere solche Systeme, die eine Vielzahl an hohe Verlustwärme erzeugende Bauteile aufweisen, zur effektiven Ableitung der Verlustwärme mit einer Kühlanordnung, beispielsweise einer Luft- oder einer Flüssigkeits-Kühlanordnung, versehen. Bei einer Luft-Kühlanordnung muß eine entsprechende Dimensionierung der Kühlkörper erfolgen, sowie eine angemessene Anzahl an Lüftern vorgesehen werden, die eine Umströmung von Luft um das hitzeentwickelnde Bauteil und den damit verbundenen Kühlkörper bewirken.

Zur Integration der Leistungsbauteile in eine Flüssigkeits-Kühlanordnung werden diese mit einem mit Kühlflüssigkeit versehenen Kühlkörper verbunden. Der Kühlkörper ist über Kühlleitungen mit der Kühlanordnung verbunden. Durch die Kühlleitungen zirkulierende Kühlflüssigkeit wird einem Wärmetauscher zugeführt.

Luft-Kühlanordnungen bedingen aufwendige Zu- und Abluftvorrichtungen. Insbesondere führt eine hohe Anzahl an den im Computersystem angeordneten Lüftern zu erhöhter Geräuschentwicklung und zur Verringerung des Platzangebots innerhalb eines Computergehäuses. Die Integration flüssigkeitsführender Kühlkörper in Flüssigkeits-Kühlanordnungen gestaltet sich insbesondere bei einem vorzunehmenden Austausch er zu kühlenden Komponente schwierig, da der Kühlkreislauf unterbrochen werden muß und/oder der Kühlkörper vom Bauteil gelöst werden muß, was einen erheblichen mechanischen Aufwand bedeutet und mitunter auch zu einer Beschädigung der zu kühlenden Komponente führt.

Der Erfindung liegt daher die Aufgabe zugrunde, ein Kühlsystem auszubilden, welches auf eine einfache Art an eine in einem Computersystem angeordnete Kühlanordnung anbindbar ist.

Die Aufgabe wird erfindungsgemäß dadurch gelöst, daß auf dem Kühlkörper ein weiterer Kühlkörper angeordnet ist, der zur Ableitung von Verlustwärme mit einer in dem Computersystem angeordneten Kühlanordnung thermisch leitend verbunden ist.

Dabei wird vorteilhaft ein im Kühlkreislauf der Kühlanordnung integrierter Kühlkopf mit dem weiteren Kühlkörper verbunden. Hierzu sind die einander zugewandten Flächen des Kühlkopfs und des weiteren Kühlkörpers flächig ausgebildet, so daß sie sich berühren und eine thermisch leitende Verbindung herstellen. Die Flächen können planparallel ausgestaltet sein oder derart ausgeformt sein, daß eine größere Oberfläche bezüglich der sich berührenden Flächen erzielt wird. Der weitere Kühlkörper ist unmittelbar über dem Kühlkörper des wärmeentwickelnden Bauteils angeordnet und ist über Anstandsbuchsen, die zwischen dem Kühlkörper und einer Leiterplatte und zwischen der Leiterplatte und einem Gehäuseboden eines Computergehäuses angeordnet sind, fest mit dem Gehäuseboden verschraubt.

Der Kühlkopf der Kühlanordnung weist seitlich angeordnete Blattfedern auf, die zur Verbindung des Kühlkopfs mit dem weiteren Kühlkörper in den Kühlkörper eingehängt sind, den weiteren Kühlkörper mit dem Kühlkopf unter Spannung zusammendrücken und über die sich berührenden Flächen einen Wärmeübergang herstellen. Der Kühlkopf kann hierbei sowohl für eine passive oder aktive Luftkühlung als auch für eine Flüssigkeits-Kühlanordnung ausgelegt sein. Die vorgeschlagene Ausführung der Verbindung der Kühlanordnung mit dem Kühlkörper des wärmeentwickelnden Bauteils ist insbesondere in einem Wartungsfall von Vorteil. Hierzu wird die durch die Blattfedern hergestellte Verbindung zwischen Kühlkopf und dem weiteren Kühlkörper gelöst und zum Beispiel die Leiterplatte, auf der die Komponente angeordnet ist, aus dem Computersystem entfernt. Der weitere Kühlkörper kann nunmehr während einer Reparatur an eine andere Kühlanordnung, die sich beispielsweise an einem Arbeitsplatz eines Servicetechnikers befindet, angeschlossen werden.

Um eine formschlüssige Verbindung zwischen dem Kühlkörper und dem weiteren Kühlkörper zu erzielen, sind an Enden der Abstandsbuchsen jeweils Blattfedern vorgesehen, die bei einer Verschraubung des weiteren Kühlkörpers mit dem Gehäuseboden den Kühlkörper mit einer definierbaren Vorspannkraft mit dem weiteren Kühlkörper verspannen. Zwischen sich berührenden Flächen des Kühlkörpers und des weiteren Kühlkörpers liegt ein Wärmeübergangswiderstand vor, der unter Aufrechterhaltung der Verbindung auf einem konstant hohen Niveau verbleibt.

Eine besonders effektive Wärmeleitung der thermisch leitenden Verbindung des Kühlkopfes und des weiteren Kühlkörpers kann durch das Vorsehen einer Wärmeleitpaste erzielt werden.

In vorteilhafter Weise ist somit eine einfache Integration zu kühlender Komponenten an eine in einem Computersystem vorhandene Kühlanordnung ermöglicht. Die Verbindung der Komponenten an die Kühlanordnung ist mit geringem Montageaufwand realisierbar. Ein Lösen der seitlich angeordneten Blattfedern des Kühlkopfs ermöglicht auf einfache Art und Weise eine Trennung der Kühlanordnung, beispielsweise aus Wartungsgründen, von dem zu kühlenden Bauteil. Jederzeit kann auch der weitere Kühlkörper durch Lösen der Verschraubung vom Kühlkörper des Bauteils getrennt werden, ohne daß eine Unterbrechung der Verbindung der Kühlanordnung mit dem weiteren Kühlkörper erforderlich ist.

Weitere Einzelheiten und Ausgestaltungen der Erfindung sind in den Unteransprüchen angegeben.

Die Erfindung wird nachfolgend an einem Ausführungsbeispiel anhand der Zeichnung näher erläutert.

Es zeigt:

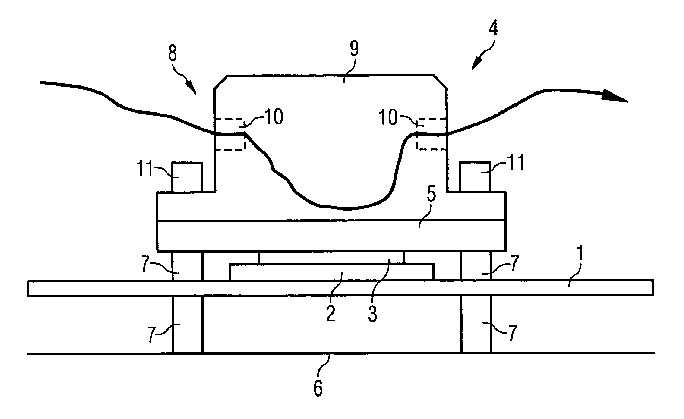

- Figur 1: eine schematische Darstellung des erfindungsgemäßen Kühlsystems zur Kühlung einer in einem Computersystem angeordneten elektronischen Komponente.

In Figur 1 ist eines schematische Darstellung des erfindungsgemäßen Kühlsystems dargestellt. Eine auf einer Leiterplatte 1 angeordnete elektronische Komponente 2, beispielsweise ein Prozessor als wärmeerzeugendes Bauteil, weist einen Kühlkörper 3 auf, der mit einem wärmeleitenden Kleber auf dem Prozessor 2 aufgeklebt oder mechanisch aufgeklemmt sein kann. Durch den Betrieb des Prozessors 2 in einem Computersystem 4 entsteht Verlustwärme, die zuverlässig abgeführt werden muß.

Ein weiterer Kühlkörper 5 ist mit einer dem Prozessor 2 abgewandten Oberseite des Kühlkörpers 3 verbunden. Zur festen mechanischen Verbindung des weiteren Kühlkörpers 5 mit einem Gehäuseboden 6 des Computersystems 4 sind zwischen dem weiteren Kühlkörper 5 und der Leiterplatte 1 bzw. zwischen der Leiterplatte 1 und dem Gehäuseboden 6 Abstandsbuchsen 7 vorgesehen, über die der weitere Kühlkörper 5 mittels Schrauben an dem Gehäuseboden 6 verschraubt wird. Mittels hier nicht dargestellter Blattfedern, die an Enden der Abstandsbuchsen 7 angeordnet sind, wird bei der Verschraubung eine definierte Druckspannung zwischen dem Kühlkörper 3 und dem weiteren Kühlkörper 5 erzielt, so daß sich berührende Flächen der Kühlkörper 3, 5 formschlüssig verbunden sind.

Eine in dem Computersystem 4 angeordnete Kühlanordnung 8 weist einen Kühlkopf 9 auf, der in einen Kühlkreislauf der Kühlanordnung 8 integriert ist. Der Kühlkreislauf kann sowohl auf Luft- als auch auf Flüssigkeitskühlung basieren. In diesem Ausführungsbeispiel ist die Kühlanordnung 8 eine Flüssigkeits-Kühlanordnung, wobei der Kühlkopf 9 Anschlüße 10 in Form einer lösbaren oder nichtlösbaren Verbindung zum Anschluß und zur Verbindung von hier nicht gezeigten Kühlleitungen der Kühlanordnung 8 aufweist und eine Kühlflüssigkeit zur Aufnahme der im Kühlkopf 9 vorliegenden Wärmeenergie die Kühlleitungen und den Kühlkopf 9 in Pfeilrichtung durchströmt. Der Kühlkopf 9 weist seitlich angeordnete Blattfedern 11 auf, die zur Verbindung des Kühlkopfs 9 mit dem weiteren Kühlkörper 5 in den weiteren Kühlkörper 5 eingehängt sind und den weiteren Kühlkörper 5 mit dem Kühlkopf 9 unter Spannung zusammendrücken. Die sich hierbei berührenden Flächen stellen die thermisch leitende Verbindung her und ermöglichen einen Wärmeübergang der Verlustwärme. Das wärmeerzeugende Bauteil 2 wird dadurch gekühlt bzw. ihm Wärme entzogen, daß zwischen dem weiteren Kühlkörper 5 und dem Kühlkopf 9 eine thermisch leitende Verbindung hergestellt ist. Diese thermisch leitende Verbindung kann bezüglich ihrer Leitfähigkeit durch die Verwendung einer Wärmeleitpaste unterstützt werden. Es wird somit der Kühlkopf 9 zur Energieabgabe von Verlustwärme an die Kühlanordnung 8 genutzt.

Durch die erfindungsgemäße Ausführung des Kühlsystems ist ein Austausch der Komponente 2 im Falle eines Fehlers auf einfache Weise durchführbar. Hierzu wird die Kühlanordnung 8 von dem weiteren Kühlkörper 5 getrennt, indem die am Kühlkopf 9 seitlich angeordneten Blattfedern 11 gelöst werden. Zur Trennung des weiteren Kühlkopfs 5 von dem Kühlkörper 3 der Komponente 2 wird die durch die Abstandsbuchsen 7 erzielte Verschraubung gelöst. Nach einem Austausch der Komponente 2 und erneuter Montage der Komponente 2 mit Kühlkörper 3 auf der Leiterplatte 1 wird auf dem Kühlkörper 3 eine Wärmeleitpaste aufgetragen und eine Verbindung zu dem weiteren Kühlkörper 5 mittels Verschraubung hergestellt. Abschließend erfolgt der Anschluß des Kühlkopfs 9 der Kühlanordnung 8 über die am Kühlkopf 9 angeordneten Blattfedern 11.

Das vorgeschlagene Kühlsystem erlaubt eine einfach durchführbare Kopplung von Kühlkörper aufweisenden Bauteilen an eine im Computersystem integrierte Kühlanordnung, so daß eine sehr effektive Abführung von erzeugter Verlustwärme erfolgen kann. Die Verbindung des Kühlkopfs mit dem weiteren Kühlkörper mittels des Blattfederverschlusses ermöglicht eine sehr schnelle Trennung der Kühlanordnung von dem zu kühlenden Bauteil, ohne daß eine Unterbrechung des Kühlkreislaufs der Kühlanordnung erfolgen muß.

### Bezugszeichenliste

- 1: Leiterplatte
- 2: Komponente, Prozessor, Bauteil
- 3: Kühlkörper
- 4: Computersystem
- 5: Weiterer Kühlkörper
- 6: Gehäuseboden
- 7: Abstandsbuchsen
- 8: Kühlanordnung
- 9: Kühlkopf
- 10: Anschlüße
- 11: Blattfedern

## Patentansprüche

1. Kühlsystem zur Kühlung einer in einem Computersystem (4) angeordneten elektronischen Komponente (2), wie z. B. einem Prozessor, mit einem Kühlkörper (3), der auf der elektronischen Komponente (2) angeordnet ist,
**dadurch gekennzeichnet, daß**
auf dem Kühlkörper (3) ein weiterer Kühlkörper (5) angeordnet ist, der zur Ableitung von Verlustwärme mit einer in dem Computersystem (4) angeordneten Kühlanordnung (8) thermisch leitend verbunden ist.

2. Kühlsystem nach Anspruch 1,
**dadurch gekennzeichnet, daß**
die Kühlanordnung (8) einen Kühlkopf (9) aufweist, der in einem Kühlkreislauf der Kühlanordnung (8) integriert ist und der mit dem weiteren Kühlkörper (5) verbunden ist.

3. Kühlsystem nach Anspruch 1 oder 2,
**dadurch gekennzeichnet, daß**
der weitere Kühlkörper (5) und der Kühlkopf (9) an aneinander zugewandten Seiten flächig ausgebildet sind und sich zur Herstellung der thermisch leitenden Verbindung berühren.

4. Kühlsystem nach Anspruch 1,
**dadurch gekennzeichnet, daß**
die Kühlanordnung (8) eine Luft-Kühlanordnung ist.

5. Kühlsystem nach Anspruch 1,
**dadurch gekennzeichnet, daß**
die Kühlanordnung (8) eine Flüssigkeits-Kühlanordnung ist.

6. Kühlsystem nach einem der vorherigen Ansprüche,
**dadurch gekennzeichnet, daß**
die elektronische Komponente (2) auf einer Leiterplatte (1) angeordnet ist und der weitere Kühlkörper (5) über zwischen dem weiteren Kühlkörper (5) und der Leiterplatte (1) und zwischen der Leiterplatte (1) und einem Gehäuseboden (6) des Computersystems (4) angeordnete Abstandsbuchsen (7) mit dem Gehäuseboden (6) fest verschraubt ist.

7. Kühlsystem nach Anspruch 6,
**gekennzeichnet durch**
Blattfedern, die zwischen den Abstandsbuchsen (7) fest eingespannt sind und die den an der elektronischen Komponente (2) angeordneten Kühlkörper (3) mit einer definierten Vorspannkraft an den weiteren Kühlkörper (5) drücken.

8. Kühlsystem nach einem der vorherigen Ansprüche,
**dadurch gekennzeichnet, daß**
der Kühlkopf (9) mittels seitlich angeordneter Blattfedern (11), die in den weiteren Kühlkörper (5) eingehängt sind, an den weiteren Kühlkörper (5) vorgespannt ist.

9. Kühlsystem nach einem der vorherigen Ansprüche,
**dadurch gekennzeichnet, daß**
die sich berührenden Flächen des Kühlkopfs (9) und des weiteren Kühlkörpers (5) zur Verbesserung der Wärmeleitfähigkeit mit einer Wärmeleitpaste versehen sind.

10. Kühlsystem nach einem der vorherigen Ansprüche,
**dadurch gekennzeichnet, daß**
die dem weiteren Kühlkörper (5) zugewandte Fläche des Kühlkopfs (9) mit einer metallischen Schutzschicht versehen ist.
